# EUROPÄISCHE PATENTSCHRIFT

(11) **EP 2 481 152 B1**
(45) Veröffentlichungstag und Bekanntmachung des Hinweises auf die Patenterteilung: **04.07.2018**
(21) Anmeldenummer: 10760292.2
(22) Anmeldetag: 21.09.2010
(51) Int. Cl.: H03K 17/94, G01V 8/14, G01S 17/02

(54) **OPTISCHER SENSOR, INSBESONDERE NÄHERUNGSSCHALTER**
OPTICAL SENSOR, IN PARTICULAR PROXIMITY SWITCH
DÉTECTEUR OPTIQUE, EN PARTICULIER DÉTECTEUR DE PROXIMITÉ

(30) Priorität: 23.09.2009 DE 102009042609
(43) Veröffentlichungstag der Anmeldung: 01.08.2012
(73) Patentinhaber: Siemens Healthcare GmbH, 91052 Erlangen (DE)
(72) Erfinder: VÖLKEL, Thomas, 90518 Altdorf (DE)
(86) Internationale Anmeldenummer: PCT/EP2010/063847
(87) Internationale Veröffentlichungsnummer: WO 2011/036137

(56) Entgegenhaltungen:
- EP-A1- 1 313 222
- EP-A1- 1 467 224
- EP-A2- 0 371 326
- US-A- 5 262 636

## Beschreibung

Die Erfindung betrifft einen optischen Sensor, insbesondere Näherungsschalter, mit zumindest einer optischen Sendeeinheit zur Erzeugung eines Sendelichtstrahls.

Ein derartiger optischer Sensor kann z.B. als Näherungsschalter, Lichtschranke, bzw. in einem Lichtgitter, Lichtvorhang, Laserscanner usw. eingesetzt werden.

An einen derartigen Sensor werden hohe Genauigkeitsanforderungen gestellt. Um diese zu erfüllen ist es üblich, den Sendelichtstrahl innerhalb eines optischen Sensors mittels Optiken, d.h. Prismen bzw. einem halbdurchlässigen Spiegel, in einen Mess- und Referenzlichtstrahl aufzuteilen. Während der Messlichtstrahl in einen Erfassungsraum abgegeben und bei Vorhandensein eines Messobjektes an diesem in Form von Reflexionslichtstrahlen zurückgeworfen wird, wird der Referenzlichtstrahl im Inneren des Sensors z.B. zum Zwecke der Synchronisation und Kalibrierung ausgewertet. Hierzu wird der Referenzlichtstrahl mit Hilfe weiterer optischer Elemente, z.B. einem Umlenkspiegel und Lichtleitern, einem Detektor zugeführt und mittels nachgeschalteter Bauelemente entsprechend ausgewertet. Zudem weisen herkömmliche optische Sensoren häufig voneinander getrennte Sende- und Empfangsoptiken auf.

Auf diese Weise kann z.B. eine Synchronisation der Messung durchgeführt werden, da nach Auswertung des Referenzlichtstrahls Beginn und Ende der Abstrahlungen des Sendelichtstrahls und damit auch die Zeiträume feststehen, in denen mit dem Empfang von Reflexionslichtstrahlen gerechnet werden kann. Falls außerhalb dieser Zeiträume Reflexionslichtstrahlung empfangen wird, so kann es sich dabei nur um unerwünschte Fremdlichtstrahlung handeln. Auf diese Weise kann auch eine Kalibrierung des Sensors zur Unempfindlichkeit gegenüber Fremdlicht vorgenommen werden. Weiterhin ist dies besonders dann von Bedeutung, wenn der Sendelichtstrahl des optischen Sensors zur Vermeidung von Übersprechen benachbarter Sensoren gepulst oder codiert ist. Bei einer anderen Ausführung kann durch Vergleich des Referenzlichtstrahls mit eintreffenden Reflexionslichtstrahlen z.B. über Interferenzmessverfahren auch der Abstand eines Messobjektes ermittelt werden.

Ein solcher Sensor ist bspw. aus der EP 1 313 222 A1 bekannt. Dieser Näherungssensor weist in einem Gehäuse ein Senderelement als optische Sendeeinheit und ein Empfängerelement als Detektor auf, wobei dem Senderelement ein Sendelichtleitelement und dem Empfängerelement ein Empfangslichtleitelement zugeordnet sind, so dass der von dem Senderelement erzeugte Sendelichtstrahl in diesem Sendelichtleitelement geführt wird und stirnseitig in Richtung eines zu detektierenden Objektes austritt. Der dort reflektierte Sendelichtstrahl tritt als Reflexionslichtstrahl in das Empfangslichtleitelement ein und wird von diesem auf das Empfängerelement geführt. Auf der Austrittsfläche des Sendelichtleitelementes ist ein Prismenkörper angeordnet, welcher zu einer Strahlaufteilung des Sendelichtstrahles führt, so dass ein Teil des Sendelichtstrahles mittels des Prismenkörpers in Richtung des Empfangslichtleitelementes abgelenkt wird, so dass mittels eines auf der Eintrittsfläche des Empfangslichtleitelementes angeordneter Prismenkörper dieser abgetrennte Teil des Sendelichtstrahles in das Empfangslichtleitelement ablenkt und von dem Empfängerelement detektiert werden kann.

Bei einem in der Sicherheitstechnik eingesetzten optischen Sensor kann der aus dem Sendelichtstrahl abgezweigte Referenzlichtstrahl auch für eine Funktionsüberwachung des Sensors verwendet werden. Dabei kann einerseits die Funktionsfähigkeit der Vorrichtung zur Erzeugung des Sendelichtstrahls, z.B. einer LED- oder Lasersendeeinheit, aber auch der Detektor und die nachgeschaltete Elektronik überprüft werden. Weiterhin kann mit Hilfe eines inneren Referenzlichtstrahls besonders die Verschmutzung der Optik von im industriellen Umfeld eingesetzten optischen Sensoren überwacht werden.

Diese bekannten Ausführungen weisen eine Fülle von Nachteilen auf. So verursachen die zur Aufteilung des Sendelichtstrahls in einen Mess- und Referenzlichtstrahl erforderlichen optischen Elemente und auch die zur Auswertung des Referenzlichtstrahls erforderlichen elektrischen Elemente einen besonderen Aufwand. Zudem wird der Sendelichtstrahl durch die Strahlaufteilung geschwächt, so dass die zur Erzeugung des Sendelichtstrahls vorgesehenen Vorrichtungen gegebenenfalls größer dimensioniert werden müssen, um einen ausreichend starken Messlichtstrahl abzugeben.

Ein weiterer Nachteil wird in den getrennten Ansteuerungen der Elemente zur Erzeugung des Sendelichtstrahls und der Elemente zur Auswertung der Referenz- und Reflexionslichtstrahlung einschließlich der voneinander getrennten Sende- und Empfangsoptiken gesehen. Zur Erzielung einer ausreichenden Messgenauigkeit müssen in einem solchen Fall erhebliche Maßnahme zur Kalibrierung der einzelnen Lichtsignale und zur Synchronisation der Signallaufzeiten vorgesehen werden.

Ein weiterer als Näherungsschalter eingesetzte Sensor ist aus der US 5 262 636 A bekannt, bei dem mittels einer Laserdiode ein Sendelichtstrahl in Richtung eines zu detektierenden Objektes erzeugt wird, wobei in rückwärtiger Richtung der Laserdiode ein Restlicht austritt, welches von einer Photodiode detektiert wird. Das an dem Objekt reflektierte Licht wird gleichzeitig von dieser Photodiode detektiert, wobei in diesem Strahlengang des reflektierten Lichtstahles die Laserdiode angeordnet ist.

EP 0 371 326 A2 offenbart eine Einrichtung zur Detektion von Fahrzeugen. Hierzu wird ein Laserstrahl ausgesendet, der über einen rotierenden Spiegel abgelenkt wird. Beim Auftreffen des Laserstrahls auf eine Gaswolke wird der Laserstrahl gestreut, und das daraus resultierende Streulicht wird durch eine Empfangsoptik fokussiert und von einem Detektor ausgewertet.

EP 1 467 224 A1 offenbart einen optischen Detektor. Licht wird von einem organischen Halbleiter ausgesendet, an einem Objekt gestreut und anschließend von einem Photodetektor empfangen. Zwischen Lichtquelle und Photodetektor ist dabei eine optische Barriere angeordnet.

Der Erfindung liegt die Aufgabe zu Grunde einen optischen Sensor derart weiterzubilden, so dass dieser die oben beschriebenen Nachteile nicht mehr aufweist.

Diese Aufgabe wird durch den in Anspruch 1 beschriebenen optischen Sensor gelöst. Vorteilhafte Ausführungen der Erfindung sind in den Unteransprüchen angegeben.

Der besondere Vorteil der Erfindung liegt darin, dass ein photosensitiver Flächendetektor mit semitransparenten Eigenschaften eingesetzt wird, welcher sowohl vom Sendelichtstrahl der optischen Sendeeinheit durchstrahlt wird, als auch als Empfänger für die von einem Objekt zurückgeworfene Reflexionslichtstrahlung dient. Es ist somit quasi nur ein Strahlenverlauf vorhanden, dessen Lichtstärke sowohl als Abstrahlung in Form des Sendelichtstrahls, als auch als Rückstrahlung in Form von Reflexionslichtstrahlung von einem einzigen photosensitiven Flächendetektor erfasst und einer nachgeschalteten Elektronik ausgewertet wird.

Diese Ausführung bietet eine Fülle von Vorteilen. Da bei dem erfindungsgemäßen optischen Sensor keine Strahlaufteilung mit entsprechend verteilten optischen Elementen vorgenommen wird, weist der Sendelichtstrahl eine deutlich größere Sendeleistung auf, so dass die optische Sendeeinheit zur Strahlerzeugung kleiner dimensioniert werden kann. Da der photosensitive Flächendetektor eine gemeinsame Detektorfläche sowohl für das vom Sensor ausgehende als auch für das in den Sensor einfallende Licht bereitstellt, ist eine gemeinsame Optik ausreichend.

Ein besonderer Vorteil dieser Anordnung liegt darin, dass auf Grund der Messung beider Lichtpegel mit demselben photosensitiven Flächendetektor, diese bei Auswertungen ohne vorherige Korrekturfaktoren direkt in Korrelation zueinander gesetzt werden können. Weiterhin ist keine Synchronisation zwischen der Ansteuerung der Sendeeinheit und der Auswerteeinheit am Ausgang des Flächendetektors notwendig, da die zeitliche Sendeinformation in dem einzigen, hin- und zurücklaufenden Sende- und Reflexionslichtstrahl enthalten ist. Es ist somit nur eine einzige Auswerteeinheit für die analogen Messsignale des photosensitiven Flächendetektors erforderlich. Schließlich ist auch keine separate Überwachungseinheit für die optische Sendeeinheit zur Strahlerzeugung notwendig. Vielmehr kann die Funktionsüberwachung der Sendeeinheit ebenfalls über den photosensitiven Flächendetektor und die nachgeschaltete Auswerteeinheit erfolgen.

Gemäß einer vorteilhaften Ausführung der Erfindung weist der photosensitive Flächendetektor eine organische Polymerschicht als photosensitives Substrat auf. Besonders vorteilhaft kann dabei der photosensitive Flächendetektor Form einer "Organic Photosensitive Diode" (OPD) ausgeführt sein. Ein solches Element bietet den Vorteil, ohne optische Umlenkeinheiten gleichzeitig ein Sende- und ein Empfangssignal zu erfassen. Der transparente organische photosensitive Detektor wandelt nämlich nur einen Teil des einfallenden Sendelichtstrahls in elektrische Signale um, während ein Großteil der Lichtstrahlung den Detektor in der Art eines Messlichtstrahls durchdringt. Die jeweils gewünschte Transparenz des Detektors kann im Fertigungsverfahren für organische photosensitive Detektoren mit Schichtdicken für Anode, Kathode, Polymer usw. im Submikrometerbereich, d.h. einigen 100 nm, eingestellt werden.

Die Erfindung und besonders vorteilhaften Ausführung derselben werden nachfolgend anhand der Figuren 1 bis 4 näher erläutert. Dabei zeigt
- FIG 1: einen beispielhaften, schematischen Aufbau eines opti-schen Sensors gemäß der Erfindung in der Art eines Blockschaltbildes,
- FIG 2: einen Detailausschnitt für eine besonders vorteilhafte Ausführung eines photosensitiven Detektors, welcher im Durchtrittsbereich für den Sendelichtstrahl eine nicht photosensitive, inaktive Fläche aufweist,
- FIG 3: drei beispielhafte Ansteuerimpulse zur Generierung von gepulsten Sendelichtstrahlen der Sendeeinheit,
- FIG 4: die zu den Ansteuerimpulsen von FIG 3 gehörigen und bei drei beispielhaften, unterschiedlichen Anwendungsfällen in der Messsignalleitung des Flächendetektors hervorge-rufenen Signalpegel des analogen Messsignalstromes, und
- FIG 5: eine Parallelanordnung von optischen Sensoren gemäß der Erfindung in Form eines optischen Vorhangs.

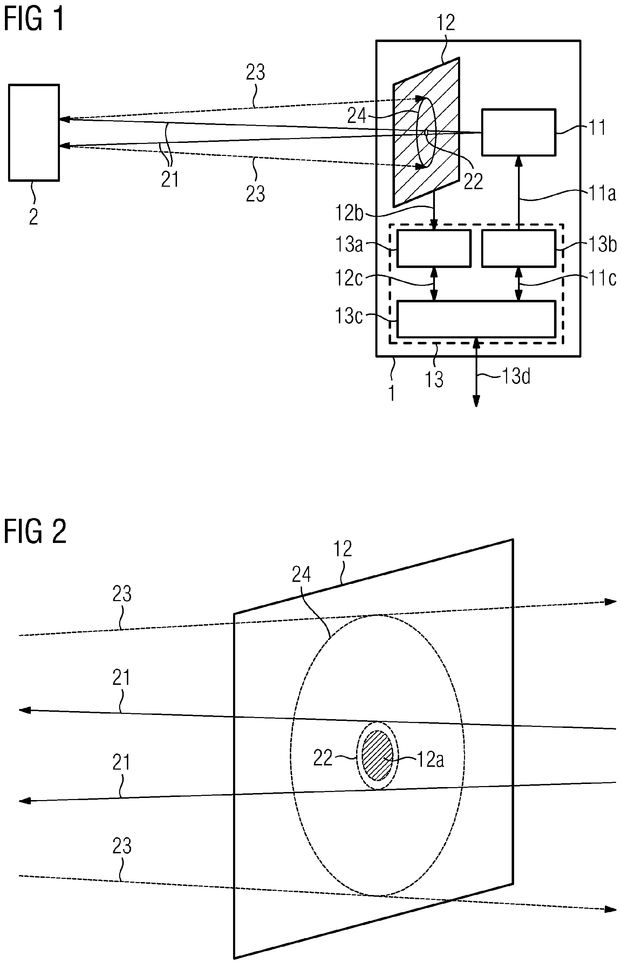

FIG 1 zeigt den schematischen Aufbau eines beispielhaften optischen Sensors 1 gemäß der Erfindung in der Art eines Blockschaltbildes. Dieser ist in Form eines Einzelsensors 1 mit einem annähernd punktförmigen Überwachungsbereich ausgeführt. Dabei enthält der Sensor 1 einen photosensitiven Flächendetektor 12 mit semitransparenten Eigenschaften, welcher zum einen von einer optischen Sendeeinheit 11 mit einem Sendelichtstrahl 21 quasi von hinten durchstrahlt wird.

Dieser Sendelichtstrahl 21 ist in der Art eines Messlichtstrahls auf ein zu detektierendes Objekt gerichtet, im Beispiel der FIG 1 auf eine Kiste 2, und ruft auf der Oberfläche des photosensitiven Flächendetektors 12 einen Sendelichtfleck 22 hervor. Dieser wird vom Flächendetektor 12 erfasst und über einen analogen Messwerteausgang 12b als Istwert des photoelektrischen Stroms des Flächendetektors 12 zur Weiterverarbeitung an eine Steuerung 13 übergeben. Diese kann mit diesem Messwert z.B. das Vorhandensein des Sendelichtstrahls und dessen Intensität erfassen, und auf diese Weise z.B. eine Funktionsüberwachung durchführen.

Trifft von der optischen Sendeeinheit 11 emittierte Sendelichtstrahl 21 auf das Objekt 2 auf, so wird dieser an dem Objekt reflektiert, in Form von Reflexionslichtstrahlung 23 zum optischen Sensor 1 zurückgeworfen und trifft in Form eines Reflexionslichtflecks 24 wieder auf der Oberfläche des photosensitiven Flächendetektors 12 auf. Auch dieser wird vom Flächendetektor 12 erfasst und über den analogen Messwerteausgang 12b als Istwert des davon im Flächendetektor 12 hervorgerufenen photoelektrischen Stroms zur Weiterverarbeitung an die Steuerung 13 übergeben. Diese kann mit diesem Messwert z.B. das Vorhandensein eines Objektes bzw. dessen Intensität erfassen, und auf diese Weise in der Art eines Näherungsschalters z.B. eine Objektdetektion und Abstandbestimmung durchführen. Dies wird am Beispiel der nachfolgenden Figuren noch näher erläutert werden.

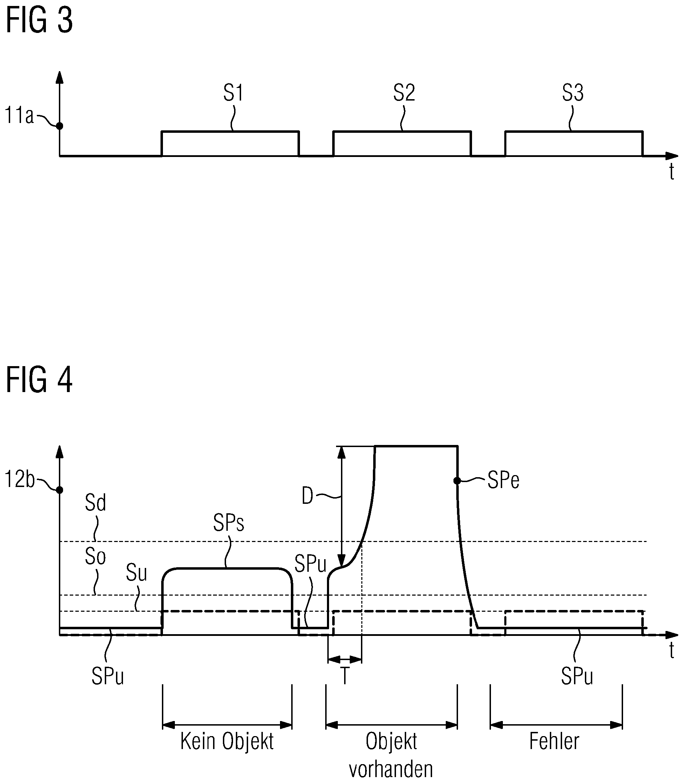

In FIG 1 sind weiterhin die wesentlichen Elemente einer beispielhaften Steuerung 13 exemplarisch dargestellt. Dabei ist der photosensitive Flächendetektor 12 über einen analogen Messwerteausgang 12b mit einer Auswerteeinheit 13a verbunden. Diese wertet den vom Sendelichtstrahl bzw. von einer Kombination aus Sendelichtstrahl und Reflexionsstrahlung bzw. nur von diffusem Umgebungsstreulicht hervorgerufenen Istwert des photoelektrischen Stroms des Flächendetektors 12 aus. Eine beispielhafte Art einer solchen Auswertung wird nachfolgend mittels der Figuren 3 und 4 noch näher erläutert werden. Die Auswerteeinheit 13a führt diese Messwerte und eventuell zusätzliche Auswertungsergebnisse vorzugsweise über eine digitale Datenschnittstelle 12c einer Kontrolleinheit 13c zu, die z.B. über eine Kommunikationsschnittstelle 13d zum Anschluss an einen Datenbus verfügt.

Im Allgemeinen koordiniert die Kontrolleinheit 13c über die Ein- und Ausgänge 12c, 11c und 13d, d.h. bevorzugt über digitale Datenschnittstellen, die Interaktion des Sensors 1 mit dem Umfeld, das Zusammenspiel von Sendeeinheit 11 mit Detektor 12 und die internen Überwachungsfunktionen des Sensors 1. So parametriert die Kontrolleinheit 13c z.B. eine Ansteuerung 13b für die Sendeeinheit 11 so, dass diese Pulsmuster zur getakteten Ein- und Ausschaltung der Strahlerzeugung über die Ansteuerleitung 11a abgibt.

Die Pulsung des Sendelichtstrahls 21 ermöglicht z.B. eine Laufzeitmessung zum Zecke einer Bestimmung des Abstandes zwischen Sensor 1 und Objekt 2. Weiterhin ist es damit möglich, die Fremdlichtempfindlichkeit des optischen Sensors 1 zu reduzieren oder z.B. bei einer LED, Laser- oder OLED Diode als Sendeeinheit 11 vorgeschriebene Emissionsklassen einzuhalten. Zur endgültigen Strahlerzeugung an der optischen Schnittstelle des Sensors 1 kann dem kombinierten Strahlengang aus der Sende- und Reflexionslichtstrahlung 21, 23 eine Optik vorgesetzten sein. Aus Gründen der besseren Übersicht ist eine solche in den Figuren nicht dargestellt.
Bei einer bevorzugten Ausrichtung von Sendeeinheit 11 zu photosensitivem Flächendetektor 12 trifft der Sendelichtstrahl 21 annähernd orthogonal auf die Oberfläche des photosensitiven Flächendetektors 12 auf. Ist in diesem Fall der Sensor 1 geradlinig auf das Objekt 2 ausgerichtet, so trifft die Reflexionslichtstrahlung 23 unter Bildung eines Reflexionslichtflecks 24 so auf die Oberfläche des photosensitiven Flächendetektors 12 auf, dass dieser den in einem Zentrum liegenden Sendelichtfleck 22 annähernd konzentrisch umgibt. Besonders vorteilhaft sind der photosensitive Flächendetektor 12 und die Sendeeinheit 11 so ausgerichtet, dass Reflexionslichtstrahlen 23 möglichst axial zum Sendelichtstrahl 21 auf den Flächendetektor 12 treffen.
In FIG 2 ist eine solche Anordnung am Beispiel einer perspektivischen Seitenansicht auf den photosensitiven Flächendetektor 12 gezeigt. Gemäß einer vorteilhaften weiteren Ausführung der Erfindung weist der Flächendetektor 12 an der Stelle eine inaktive Fläche 12a auf, an welcher der Sendestrahl 21 nach Außen tritt. Da diese Fläche 12a kleiner ist als die vom Sendelichtfleck 22 überstrichene Fläche, wird nur ein Teil des Sendestrahls 21 vom Sensor 1 detektiert, während der Hauptanteil undetektiert und vor allem ohne Abschwächung nach außen treten kann. Auf diese Weise kann der Dynamikbereich des Sensors erheblich verbessert werden, ohne dass damit Zusatzfunktionen wie z.B. die Funktionsüberwachung, eingeschränkt werden. Bei Verwendung einer "Organic Photosensitive Diode" (OPD) als photosensitiven Flächendetektor kann die inaktive Fläche 12a z.B. bei der Herstellung des transparenten Detektors durch geeignete Masken für Anode, Kathode und des polymeren Halbleiters bzw. durch ein Loch im Trägermaterial realisiert werden.

In FIG 3 sind beispielhaft drei Ansteuerimpulse S1, S2, S3 gezeigt, welche über die Signalleitung 11a zur Generierung von gepulsten Sendelichtstrahlen 21 der Sendeeinheit 11 zugeführt werden. Die davon bei unterschiedlichen Anwendungsfällen in der Messsignalleitung 12b des Flächendetektors 12 hervorgerufenen Signalpegel des analogen Messsignalstromes sind darunter liegend in Figur 4 dargestellt.

So zeigt FIG 4 im linken Bereich den Signalpegel SPs des Photostromes für den Fall, dass durch den Ansteuerimpuls S1 zwar ein Sendelichtstrahl hervorgerufen wird, dieser aber mangels eines im Strahlengang befindlichen Objektes nicht reflektiert wird. In diesem Fall wird also nur der Pegel SPs des Sendelichtstrahls gemessen.

Gemäß einer vorteilhaften weiteren Ausführung der Erfindung können z.B. von der Auswerteeinheit 13a zur besseren Auswertung des Messsignals Schwellwerte vorgesehen sein. Im Beispiel der Figuren 3 und 4 sind hierzu beispielsweise eine untere Überwachungslichtschwelle Su, eine obere Überwachungslichtschwelle So und eine ganz oben liegende Detektionslichtschwelle Sd vorgesehen.

So unterschreitet der messbare Signalpegel des Photostromes in FIG 4 ganz links die untere Überwachungslichtschwelle Su. Da in diesem Bereich auf Grund des Fehlens eines Ansteuerimpulses in FIG 3 offensichtlich kein Sendelichtstrahl erzeugt wird, kann dieser Signalpegel nur von diffusem Streulicht hervorgerufen werden. Dennoch kann dieser Messwert z.B. von der Kontrolleinheit 13c oder der Auswerteeinheit 13a zur Kalibrierung des optischen Sensors 1 verwendet werden. Dagegen überschreitet der Signalpegel SPs für die Dauer des Ansteuerimpulses S1 die obere Überwachungslichtschwelle So. Ein Messwert mit dieser Größe kann von der Kontrolleinheit 13c oder der Auswerteeinheit 13a dazu verwendet werden, um die ordnungsgemäße Funktionsfähigkeit des optischen Sensors 1 festzustellen.

Weiterhin zeigt FIG 4 im mittleren Bereich den Signalpegel SPe des Photostromes für den Fall, dass durch den Ansteuerimpuls S2 ein Sendelichtstrahl hervorgerufen und dieser auf Grund eines im Strahlengang befindlichen Objektes reflektiert wird. In diesem Falle addiert sich zum Pegel des Sendelichtstrahls der Pegel des Reflektionslichtstrahls, so dass die obere Überwachungslichtschwelle So überschritten wird. Der endgültige Signalpegel SPe wird allerdings erst nach einer Verzugszeit T erreicht. Diese entspricht der Laufzeitzeit des Sendelichtstrahls 21, um nach dem Verlassen des Sensors und der Reflexion an einem Objekt wieder auf den photosensitiven Flächendetektor aufzutreffen. Im Beispiel der FIG 4 kann diese Verzugszeit T z.B. von der Auswerteeinheit 13a bestimmt werden aus der vorderen Flanke des Ansteuerimpulses S2 und dem Zeitpunkt, in dem der gemessene Pegel die Detektionslichtschwelle Sd überschreitet. Mit Hilfe der Lichtgeschwindigkeit und dem gemessenen Wert der Verzugszeit T kann z.B. von der Auswerteeinheit 13a der Abstand zwischen Sensor 1 und Objekt 2 bestimmt werden.

In FIG 4 ist auch der Dynamikbereich D des Sensors eingetragen, d.h. der Unterschied zwischen dem Signalpegel SPs des Sendelichtstrahls und dem maximalen Signalpegel SPe im Falle eines im Sendelichtstrahl befindlichen Objektes. Zur Erhöhung des Dynamikbereiches D kann der photosensitiver Flächendetektor, wie am Beispiel von Bild 2 bereits erläutert, mit einer nichtsensitiven, inaktiven Fläche ausgestattet werden.

Schließlich zeigt FIG 4 im rechten Bereich den Signalpegel SPu des Photostromes für den Fall, dass trotz eines Ansteuerimpulses S3 z.B. auf Grund eines Defekts im Sensor 1 kein Sendelichtstrahl hervorgerufen wird. Da in diesem Fall ein unterhalb der Überwachungslichtschwelle Su liegender und allenfalls von Umgebungsstreulicht hervorgerufener Signalpegel SPu detektierbar ist, können z.B. von der Kontrolleinheit 13c Diagnosemeldungen generiert werden, welche z.B. einen Totalausfall der Sendeeinheit oder einen durch Alterung bedingten, unzulässigen Rückgang der Sendeleistung signalisieren.

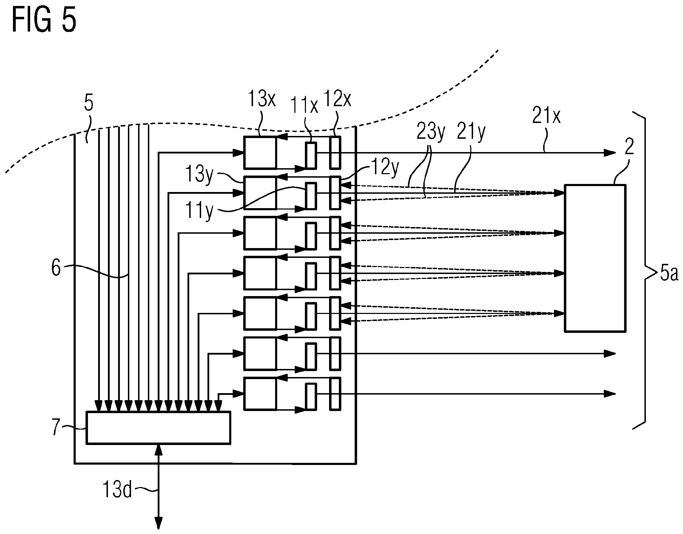

In FIG 5 ist schließlich eine vorteilhafte Parallelanordnung von optischen Sensoren gemäß der Erfindung in Form eines optischen Vorhangs gezeigt. Bei einer derartigen beispielhaften kaskadierten Ausführung der Erfindung sind eine Vielzahl von Einzelsensoren in einem Sensor 5 nebeneinander angeordnet, so dass die von den Einzelsensoren erzeugten Sendelichtstrahlen eine Art Lichtvorhang 5a bilden.

So ist im Beispiel der FIG 5 ein Zustand gezeigt, bei dem beispielsweise ein quasi "im Vorhang befindliches" Objekt 2 von vier Einzelsensoren des Sensors 5 durch die Reflexion von deren Sendelichtstrahlen erfasst wird, während die Sendelichtstrahlen der anderen Einzelsensoren daran vorbei gehen. So geht beispielsweise der Sendelichtstrahl 21x des oberen Einzelsensors, welcher erfindungsgemäß eine optische Sendeeinheit 11x, einen davon durchstrahlten photosensitiven Flächendetektor 12x und eine gemeinsame Substeuerung 13x aufweist, an dem Objekt 2 vorbei. Dagegen trifft der Sendelichtstrahl 21y des darunter befindlichen Sensors, welcher erfindungsgemäß ebenfalls eine optische Sendeeinheit 11y, einen davon durchstrahlten photosensitiven Flächendetektor 12y und eine gemeinsame Substeuerung 13y aufweist, auf das Objekt 2 auf. Die dabei erzeugte Reflexionslichtstrahlung 23y wird ebenfalls von dem Flächendetektor 12y erfasst und in der oben beschriebenen Weise verarbeitet.

Im Beispiel der FIG 5 werden schließlich die Messwerte der Einzelsensoren über Kommunikationsverbindungen 6 zur weiteren Verarbeitung an eine zentrale Steuerung 7 übermittelt. Diese kann wiederum über eine Kommunikationsschnittstelle 13d und einen Datenbus mit übergeordneten Beobachtungs- und Steuereinheiten kommunizieren.

## Patentansprüche

1. Optischer Sensor (1), insbesondere Näherungsschalter, mit zumindest
a) einer optischen Sendeeinheit (11) zur Erzeugung eines Sendelichtstrahls (21),
b) einem photosensitiven Flächendetektor (12), welcher dazu ausgelegt ist, einen Reflexionslichtfleck (24) zu erfassen, der von dem an einem Objekt (2) reflektierten Sendelichtstrahl (21) als Reflexionslichtstrahl (23) hervorgerufen wird, und
c) einer Auswerteeinheit (13) für den photoelektrischen Strom (12b) des photosensitiven Flächendetektors (12) zumindest zur Detektion des Objekts (2), wobei
- die Sendeeinheit (11) derart angeordnet ist, dass der photosensitive Flächendetektor (12) von dem auf das Objekt (2) gerichteten Sendelichtstrahl (21) durchstrahlt wird, so dass der Sendelichtstrahl (21) nach Durchtritt durch einen Durchtrittsbereich des Flächendetektors (12) auf das Objekt (2) trifft,
**dadurch gekennzeichnet, dass**
- der photosensitive Flächendetektor (12) semitransparente Eigenschaften aufweist, und
- der photosensitive Flächendetektor (12) dazu ausgelegt ist, einen Sendelichtfleck (22) zu erfassen, der durch den Sendelichtstrahl (21) auf dem photosensitiven Flächendetektor (12) hervorgerufen wird.

2. Optischer Sensor (1) nach Anspruch 1,
**dadurch gekennzeichnet, dass** der photosensitive Flächendetektor (12) und die Sendeeinheit (11) so ausgerichtet sind, dass Reflexionslichtstrahlen (23) möglichst axial zum Sendelichtstrahl (21) auf den Flächendetektor (12) treffen.

3. Optischer Sensor (1) nach Anspruch 1 oder 2,
**dadurch gekennzeichnet, dass** der photosensitive Flächendetektor (12) im Durchtrittsbereich für den Sendelichtstrahl (21) eine nicht photosensitive, inaktive Fläche (12a) aufweist.

4. Optischer Sensor (1) nach einem der vorangegangenen Ansprüche, **dadurch gekennzeichnet, dass** der photosensitive Flächendetektor (12) eine organische Polymerschicht als photosensitives Substrat aufweist.

5. Optischer Sensor (1) nach Anspruch 4, **dadurch gekennzeichnet, dass** eine "Organic Photosensitive Diode" (OPD) als photosensitiver Flächendetektor (12) mit semitransparenten Eigenschaften vorgesehen ist.

## Claims

1. Optical sensor (1), in particular a proximity switch, having at least
a) an optical transmitting unit (11) for generating a transmission light beam (21),
b) a photosensitive area detector (12) which is designed to capture a reflection light spot (24) which is caused by the transmission light beam (21) reflected at an object (2) as a reflection light beam (23), and
c) an evaluation unit (13) for the photoelectric current (12b) of the photosensitive area detector (12) at least for detecting the object (2), wherein
- the transmitting unit (11) is arranged in such a manner that the photosensitive area detector (12) is irradiated by the transmission light beam (21) aimed at the object (2), with the result that the transmission light beam (21) strikes the object (2) after passing through a passage region of the area detector (12), **characterized in that**
- the photosensitive area detector (12) has semitransparent properties, and
- the photosensitive area detector (12) is designed to capture a transmission light spot (22) which is caused by the transmission light beam (21) on the photosensitive area detector (12).

2. Optical sensor (1) according to Claim 1,
**characterized in that** the photosensitive area detector (12) and the transmitting unit (11) are oriented in such a manner that reflection light beams (23) strike the area detector (12) as axially as possible with respect to the transmission light beam (21) .

3. Optical sensor (1) according to Claim 1 or 2,
**characterized in that** the photosensitive area detector (12) has a non-photosensitive inactive area (12a) in the passage region for the transmission light beam (21).

4. Optical sensor (1) according to one of the preceding claims, **characterized in that** the photosensitive area detector (12) has an organic polymer layer as a photosensitive substrate.

5. Optical sensor (1) according to Claim 4, **characterized in that** an "organic photosensitive diode" (OPD) is provided as the photosensitive area detector (12) with semitransparent properties.

## Revendications

1. Capteur (1) optique, notamment commutateur de proximité, comprenant au moins
a) une unité (11) d'émission optique pour produire un faisceau (21) lumineux d'émission,
b) un détecteur (12) de surface photosensible, conçu pour détecter une tache (24) lumineuse de réflexion provoquée par le faisceau (21) lumineux d'émission réfléchi sur un objet (2) comme faisceau (23) lumineux de réflexion, et
c) une unité (13) d'exploitation du courant (12b) photoélectrique du détecteur (12) de surface photosensible, au moins pour la détection de l'objet (2), dans lequel
- l'unité (11) d'émission est disposée de manière à ce que le détecteur (12) de surface photosensible soit traversé par le faisceau (21) lumineux d'émission dirigé sur l'objet (2), de sorte que le faisceau (21) lumineux d'émission arrive sur l'objet (2), après avoir traversé une région de traversée du détecteur (12) de surface,
**caractérisé en ce que**
- le détecteur (12) de surface photosensible a des propriétés de semi-transparence, et
- le détecteur (12) de surface photosensible est conçu pour détecter une tache (22) lumineuse d'émission provoquée par le faisceau (21) lumineux d'émission sur le détecteur (12) de surface photosensible.

2. Capteur (1) optique suivant la revendication 1, **caractérisé en ce que** le détecteur (12) de surface photosensible et l'unité (11) d'émission sont orientés, de manière à ce que des rayons (23) lumineux de réflexion arrivent sur le détecteur (12) de surface, le plus possible axialement, par rapport au faisceau (21) lumineux d'émission.

3. Capteur (1) optique suivant la revendication 1 ou 2, **caractérisé en ce que** le détecteur (12) de surface photosensible a, dans la région de traversée du faisceau (21) lumineux d'émission, une surface (12a) inactive non photosensible.

4. Capteur (1) optique suivant l'une des revendications précédentes, **caractérisé en ce que** le détecteur (12) de surface photosensible a une couche de polymère organique comme substrat photosensible.

5. Capteur (1) optique suivant la revendication 4, **caractérisé en ce qu'**il est prévu une « organic photosensitive diode » (OPD) comme détecteur (12) de surface photosensible à propriétés de semi-transparence.
